# DEMANDE DE BREVET EUROPEEN

(11) **EP 2 096 676 A1**
(43) Date de publication de la demande: **02.09.2009**
(21) Numéro de dépôt: 09153744.9
(22) Date de dépôt: 26.02.2009
(51) Int. Cl.: H01L 29/49, H01L 29/786

(54) **Procédé de fabrication d'un dispositif semi-conducteur à grille enterrée et circuit intégré correspondant.**

(30) Priorité: 27.02.2008 FR 0851265
(71) Demandeur: Commissariat à l'Energie Atomique, Bâtiment D "Le Ponant" 25 rue Leblanc 75015 Paris (FR)
(72) Inventeur: Bernard, Emilie, 38100, GRENOBLE (FR); Guillaumot, Bernard, 38120, LE FONTANIL (FR); Coronel, Philippe, 38530, BARRAUX (FR); Vizioz, Christian, 38220, SAINT PIERRE DE MESAGE (FR)
(74) Mandataire: Zapalowicz, Francis

(57) **Abrégé**

L'invention concerne un procédé de fabrication d'un dispositif semi-conducteur comportant une région semi-conductrice de canal et une région de grille, la région de grille comprenant au moins une partie enterrée s'étendant sous la région de canal. La formation de la partie enterrée de la région de grille comprend :
- une formation d'une cavité sous la région de canal,
- le remplissage de la cavité par un premier matériau,
- la mise en contact avec le premier matériau, d'aluminium ou d'un deuxième matériau semi-conducteur différent du premier,
- une substitution du premier matériau par l'aluminium, ou la diffusion du second matériau semi-conducteur dans le premier matériau.

## Description

L'invention concerne les circuits intégrés, et plus particulièrement les dispositifs semi-conducteurs à grille enterrée, c'est-à-dire dont au moins une partie de la région de grille est placée en-dessous de la région de canal.

Parmi les dispositifs semi-conducteurs à grilles dites enterrées, on distingue les dispositifs à double grille planaire, c'est-à-dire dans lesquels la région de grille comporte deux grilles dont une est située au-dessus de la région de canal et l'autre est située au-dessous de la région de canal, et les dispositifs dits GAA (en anglais : "Gate All Around") dans lesquels la région de grille est formée d'une seule partie et enrobe la région de canal.

Les dispositifs à grille enterrée, qu'ils soient à double grille ou non, sont particulièrement intéressants pour des longueurs de canal inférieures à 50 nanomètres, car ils permettent de supprimer les effets dits de canaux courts tout en permettant d'obtenir une intensité du courant doublée ou triplée par rapport à un transistor classique. On rappelle ici qu'un canal court présente une distance (longueur) très faible entre la source et le drain, et que l'effet « canal court » se traduit par une diminution de la tension de seuil du transistor, ce qui peut à l'extrême limite conduire à l'obtention d'un transistor très difficilement contrôlable et aboutir au mode « perçage ».

Les dispositifs à grille enterrée connus comprennent une grille réalisée à partir de poly-silicium. Cependant, avec la réduction des dimensions pour les prochains dispositifs semi-conducteurs, une grille en poly-silicium fait apparaître de nombreuses limites telles que la poly-déplétion, une incompatibilité avec les diélectriques à haute permittivité, une résistivité de grille trop élevée.

Une solution est notamment l'utilisation d'une grille métallique, même si l'ajustement de la tension de seuil du dispositif peut nécessiter un métal dont le travail de sortie est modulable. Un exemple de dispositifs à grille métallique sont les dispositifs dits TOSI (en anglais : « totally silicided ») qui sont réalisés à partir d'une grille en poly-silicium au-dessus de laquelle est déposé, à la fin du procédé de réalisation, un métal qui diffuse dans le poly-silicium au cours d'un recuit. Un autre exemple de dispositifs à grille métallique sont les dispositifs dont la grille en poly-silicium est gravée en fin de procédé, pour y déposer à la place un métal de grille.

Dans le cas de dispositifs à grille enterrée, lorsque le matériau de grille est un siliciure de métal, le métal est déposé sur les parois latérales du poly-silicium formant la ou les régions de grille. Cependant, on obtient une mauvaise formation du siliciure de métal, notamment en raison de la longueur de diffusion limitée du métal dans le poly-silicium.

Lorsque le matériau de grille est un métal, il est déposé sous les régions de canal, à la fin du procédé de réalisation du transistor, et il doit pouvoir alors être déposable dans des cavités. Le nombre de métaux envisageables est limité et la réalisation du dispositif reste délicate.

Selon un aspect, il est proposé un procédé de fabrication d'un dispositif semi-conducteur comportant une région semi-conductrice de canal et une région de grille, la région de grille comprenant au moins une partie enterrée s'étendant sous la région de canal. La formation de la partie enterrée de la région de grille comprend :
- une formation d'une cavité sous la région de canal,
- le remplissage de la cavité par un premier matériau,
- la mise en contact avec le premier matériau, d'aluminium ou d'un deuxième matériau semi-conducteur différent du premier matériau,
- une substitution du premier matériau par l'aluminium, ou la formation d'un troisième matériau par diffusion du second matériau semi-conducteur dans le premier matériau.

La cavité peut être par exemple un volume évidé, présentant des parois supérieure et inférieure, et pouvant être ouvert et accessible de l'extérieur par une paroi latérale.

La cavité peut ainsi présenter un facteur de forme élevé, c'est-à-dire présenter par exemple une dimension très supérieure aux deux autres. Dans ce cas, la cavité pourra être accessible par une surface latérale dont les côtés sont les deux petites dimensions, tandis que la paroi supérieure et la paroi inférieure comprennent la dimension très supérieure.

La cavité est ainsi remplie par le premier matériau, et le métal de grille est formé lors d'une étape suivante. En particulier, il est possible de former le métal dans la cavité même si ce dernier ne peut pas être déposé par une méthode de dépôt conforme. Dans le cas présent, la grille métallique est formée dans la cavité par substitution d'un métal avec le premier matériau qui est, lui, déposable dans la cavité, ou bien par diffusion du second matériau semi-conducteur dans le premier matériau. Il n'y a donc qu'un seul matériau, le premier, qui est déposé dans la cavité, les autres matériaux (l'aluminium ou le second matériau semi-conducteur) étant déposés par des méthodes de dépôt classiques et dans des conditions moins contraignantes.

Il est ainsi possible notamment de réaliser des dispositifs semi-conducteurs à grille enterrée de type différent, par exemple NMOS et PMOS, en mettant en oeuvre, pour un type, une étape de substitution par l'aluminium, et pour l'autre type, une étape de diffusion pour former le troisième matériau. Le procédé présente l'avantage de différencier les deux types de dispositifs semi-conducteurs à grille enterrée durant les dernières étapes du procédé, les premières étapes étant communes à la réalisation des deux types de dispositifs semi-conducteurs à grille enterrée.

Selon un mode de mise en oeuvre, la formation de la partie enterrée de la région de grille peut comprendre également la mise en contact d'aluminium avec le troisième matériau, et une substitution du troisième matériau par l'aluminium.

Ce mode de mise en oeuvre est particulièrement avantageux lorsqu'on souhaite réaliser deux dispositifs semi-conducteurs à grille enterrée de type différent, par exemple NMOS et PMOS, avec peu d'étapes de procédé différentes. Dans un premier temps, on ne réalise que des dispositifs semi-conducteurs d'un type donné, par exemple PMOS, par formation du troisième matériau. Puis, on réalise une étape supplémentaire de substitution du troisième matériau par l'aluminium spécifiquement au niveau des dispositifs semi-conducteurs qui doivent être d'un type différent, par exemple NMOS.

Le remplissage de la cavité peut comprendre avantageusement un dépôt conforme du premier matériau dans la cavité, et l'étape de substitution ou de diffusion peut comprendre un recuit.

Le premier matériau est par exemple du poly-silicium ou du poly-silicium-germanium. En particulier, le remplissage de la cavité par du poly-silicium ou du poly-silicium-germanium peut être réalisée selon un procédé connu de l'homme du métier, par exemple par dépôt par couches atomiques ALD (en anglais : « Atomic Layer Deposition ») ou par dépôt chimique en phase vapeur CVD (en anglais : « Chemical Vapour Deposition »). Il est de préférence déposé au moment de la formation de la région de grille, et n'est pas déjà présent avant les étapes de formation du matériau de grille.

L'étape de substitution de l'aluminium au poly-silicium ou au poly-silicium-germanium peut alors notamment se faire selon le procédé décrit dans l'article : « Characteristics of Aluminum Substitution Technology for Self-Aligned Full Metal Gate nMOSFETs » de la revue IEEE Transactions on Electron Devices, vol 52, n° 5, mai 2005.

Le dépôt conforme du premier matériau permet notamment de le déposer le long des différentes parois d'une cavité présentant un facteur de forme élevé, et l'étape de substitution permet d'obtenir ensuite une région d'aluminium homogène dans la cavité précédemment remplie par le premier matériau.

Avantageusement, on peut choisir la quantité relative du premier matériau et du deuxième matériau semi-conducteur dans la partie enterrée de la grille, pour ajuster la tension de seuil du dispositif semi-conducteur. En particulier, la quantité relative du premier matériau et du deuxième matériau semi-conducteur dans la partie enterrée de la grille peut être ajustée par la durée du recuit.

La tension de seuil du dispositif semi-conducteur dépend notamment du travail de sortie du matériau de grille. Or, le travail de sortie de l'alliage du matériau de grille dépend de la quantité relative des deux matériaux dans le troisième matériau. Il est donc possible d'ajuster la tension de seuil en adaptant la durée de diffusion du deuxième matériau semi-conducteur dans le premier matériau.

Avantageusement, la formation de la grille peut comprendre :
- la formation sur la surface supérieure du substrat d'un empilement formé d'au moins une couche de silicium placée au-dessus d'une couche sacrificielle formée d'un matériau sélectivement éliminable par rapport au silicium,
- une croissance par épitaxie de silicium sur les parois latérales de l'empilement,
- une gravure anisotrope de l'empilement de manière à graver une partie du silicium épitaxié et à accéder à au moins une des extrémités de la couche sacrificielle,
- une gravure isotrope sélective de la couche sacrificielle,
- la formation, sur les parois de la cavité résultant de la gravure isotrope, d'une couche comprenant un matériau diélectrique,
- le dépôt conforme, dans la cavité, du premier matériau,
- le dépôt de l'aluminium ou du deuxième matériau semi-conducteur en contact avec le premier matériau, et
- un recuit de formation du matériau de grille.

En variante, et notamment afin d'obtenir un dispositif à grille enrobante, la formation de la région de grille peut comprendre le dépôt conforme du premier matériau autour de la partie de la région semi-conductrice de canal de manière à ce que la région de grille enrobe la région semi-conductrice de canal.

Selon un autre aspect, il est proposé un dispositif semi-conducteur comportant une région semi-conductrice de canal et une région de grille, dans lequel la région de grille comprend au moins une partie enterrée s'étendant sous la région de canal, et dans lequel la partie enterrée de la région de grille comprend de l'aluminium ou un alliage d'un premier matériau et d'un deuxième matériau semi-conducteur.

Avantageusement, l'alliage du premier matériau et du deuxième matériau semi-conducteur comprend une proportion relative en premier matériau et en deuxième matériau semi-conducteur permettant d'obtenir une tension de seuil souhaitée pour le dispositif semi-conducteur.

La région de grille peut enrober la région de canal.

Selon un autre aspect, il est proposé un circuit intégré comprenant un dispositif tel que décrit précédemment.

D'autres avantages et caractéristiques de l'invention apparaîtront à l'examen de la description détaillée de trois modes de mise en oeuvre, nullement limitatifs, et des dessins annexés, sur lesquels :
- les figures 1 à 13b illustrent de manière schématique, les principales étapes d'un premier mode de mise en oeuvre du procédé,
- les figures 14a à 15b illustrent schématiquement et partiellement une deuxième mode de mise en oeuvre,
- les figures 16 à 19 illustrent schématiquement et partiellement un troisième mode de mise en oeuvre, et
- les figures 20 à 22 illustrent schématiquement et partiellement une variante du troisième mode de mise en oeuvre.

On décrit ici par exemple un procédé de réalisation d'un transistor à grille enrobante comprenant par exemple trois régions semi-conductrices de canal dont deux sont enrobées par la région de grille.

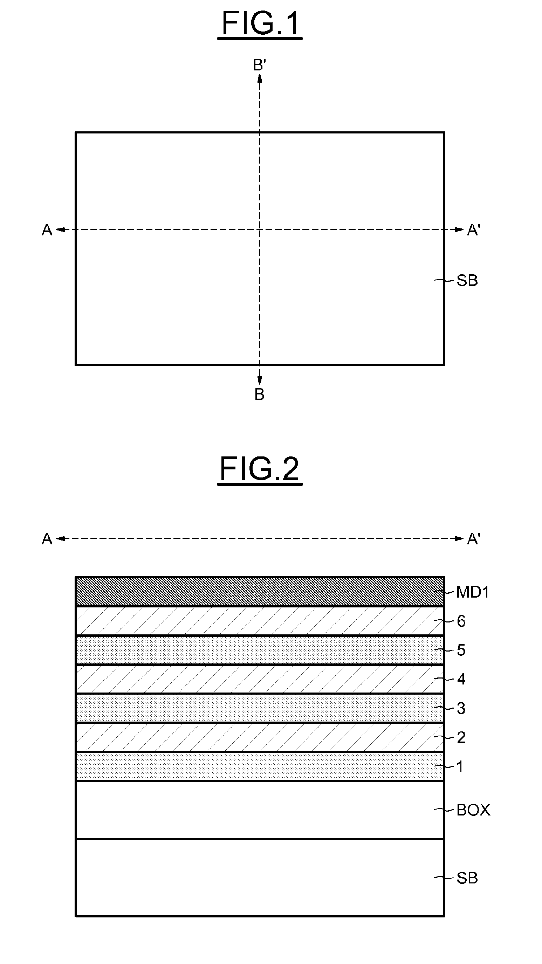

Sur la figure 1, la référence SB désigne une plaquette semi-conductrice ou substrat semi-conducteur que l'on a représenté ici en vue de dessus sous forme rectangulaire à des fins de simplification.

Dans la suite des figures, celles qui seront numérotées avec la lettre "a" correspondront à une vue en coupe selon la direction AA' de la figure 1, tandis que celles qui seront numérotées avec la lettre "b" correspondront à une vue en coupe selon la direction générale BB'.

La première phase du procédé consiste, comme illustré sur la figure 2, à former sur le substrat SB une couche isolante de base BOX surmontée d'un empilement formé d'une première couche de silicium 1, d'une deuxième couche de silicium 3 encapsulée entre deux couches sacrificielles 2 et 4, et d'une troisième couche de silicium 5 encapsulée entre la couche sacrificielle 4 et une couche sacrificielle 6. Les couches sacrificielles 2, 4 et 6 sont par exemple formées d'un alliage de silicium/germanium.

L'empilement est lui-même surmonté d'une couche de masque dur MD1, par exemple une couche de nitrure de silicium, réalisée de façon classique par dépôt.

La formation de ces couches superposées peut s'effectuer par exemple par une technique de collage moléculaire bien connue de l'homme du métier. Plus précisément, on forme la couche BOX par oxydation thermique sur le substrat SB tandis que l'on forme sur un deuxième substrat, par exemple par épitaxie non sélective, l'empilement des couches 6, 5, 4, 3, 2 et 1. On vient ensuite faire adhérer, par collage moléculaire, la surface supérieure de la couche 1 sur la surface supérieure de la couche isolante de base BOX. Après retrait du deuxième substrat, on obtient alors le substrat SB surmonté successivement des couches BOX, 1, 2, 3, 4, 5 et 6. La formation de la couche de masque dur MD1 s'effectue alors classiquement par dépôt sur la couche 6 de façon à former la structure illustrée sur la figure 2.

A titre indicatif, l'épaisseur de la couche BOX peut être comprise entre 100 et 400 nanomètres par exemple, tandis que l'épaisseur des couches 1, 3, 5, peut être comprise entre 10 et 30 nanomètres par exemple, et que l'épaisseur des couches sacrificielles 2, 4, 6 en lieu et place desquelles, comme on le verra plus en détail ci-après, seront réalisées les régions de grille, peut être comprise entre 10 et 70 nanomètres selon le type de dispositif semi-conducteur formé.

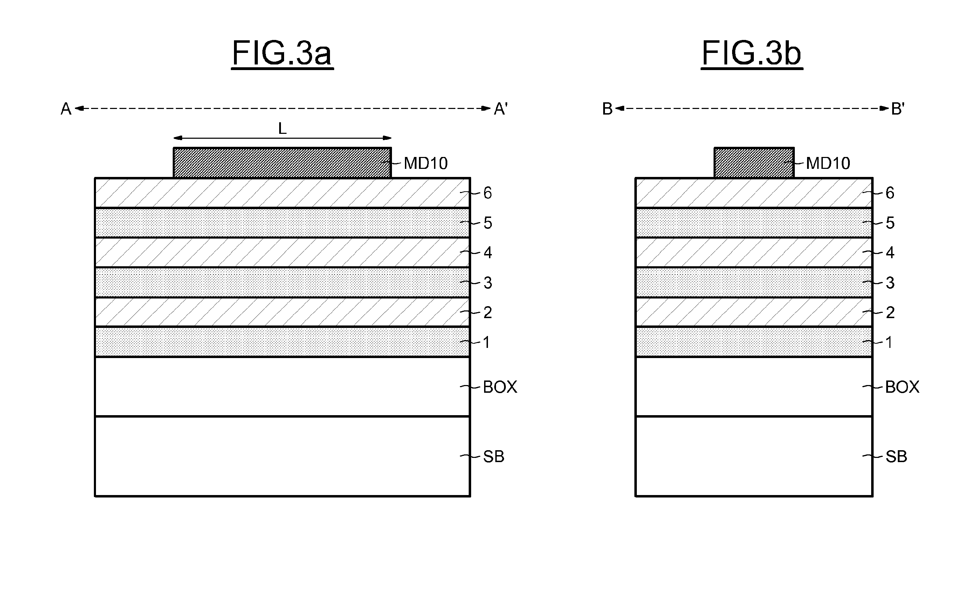

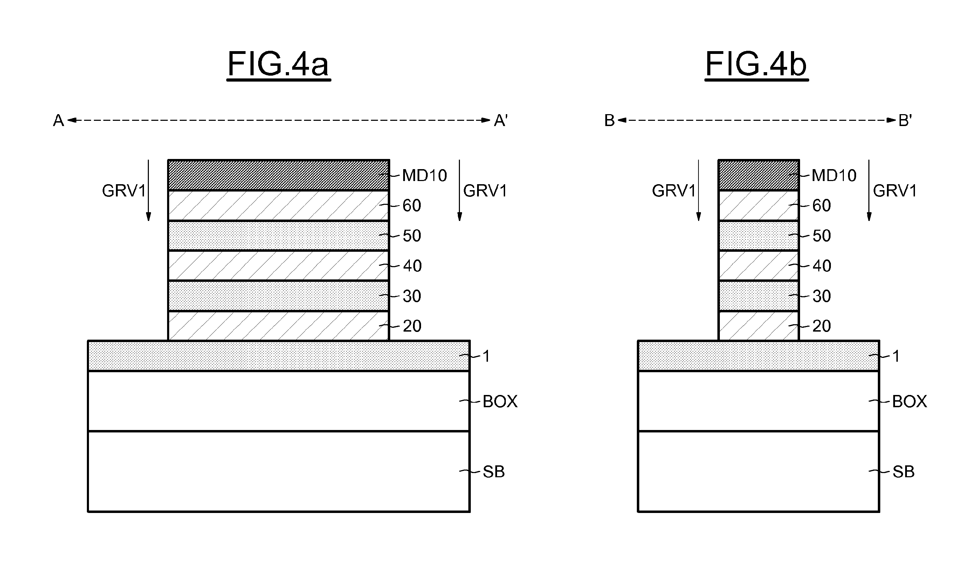

Puis, comme illustré sur les figures 3a et 3b, on forme, par une étape classique de photolithographie, un bloc de résine MD10 dans la couche de nitrure de silicium MD1, et on procède à une gravure verticale GRV1 avec arrêt sur la première couche de silicium 1. Cette gravure peut être une gravure par plasma par exemple (figures 4a et 4b). La géométrie du bloc MD10 correspond à la géométrie de la future grille du dispositif semi-conducteur, c'est-à-dire que le bloc MD10 va permettre de définir ce qui sera la longueur L des canaux du dispositif semi-conducteur.

En particulier, la longueur L des canaux sera de préférence comprise entre 20 nanomètres et 60 nanomètres, tandis que la largeur W sera comprise entre 50 nanomètres et 500 nanomètres.

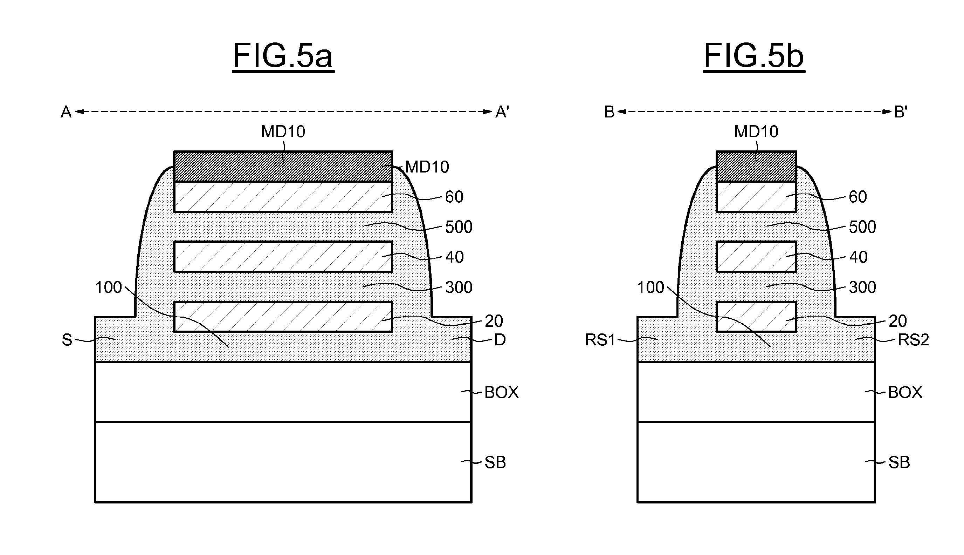

On fait croître ensuite, par épitaxie à partir des parois latérales des couches de silicium 30 et 50, et à partir de la surface supérieure de la couche de silicium 1, des régions de source S et de drain D. Les régions de source S et de drain D sont reliées par les différentes couches de silicium qui forment ainsi les canaux 100, 300, 500 du dispositif semi-conducteur (figure 5a).

Durant la formation des régions de source S et de drain D, la croissance par épitaxie du silicium entraîne également la formation de deux autres régions en silicium RS1 et RS2 (figure 5b).

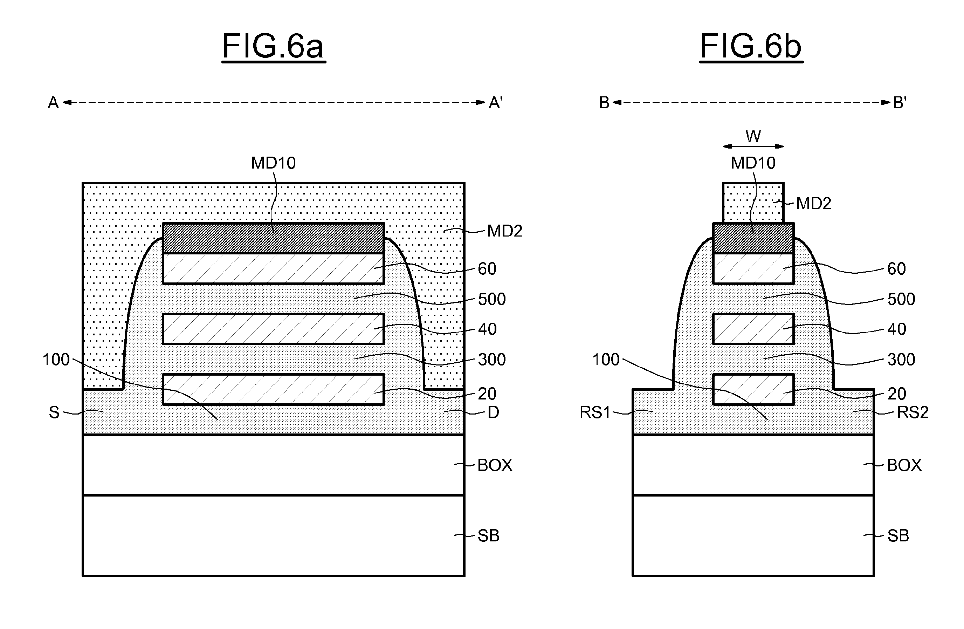

Après avoir déposé un film diélectrique, par exemple en SiO₂, sur le bloc de résine MD10, on forme alors un deuxième bloc de résine MD2, en utilisant une étape classique de photolitographie, de manière à laisser apparaître au moins les régions de silicium RS1 et RS2 (figures 6a et 6b). Le deuxième bloc de résine MD2 va permettre de définir ce qui sera la largeur W des canaux du dispositif semi-conducteur.

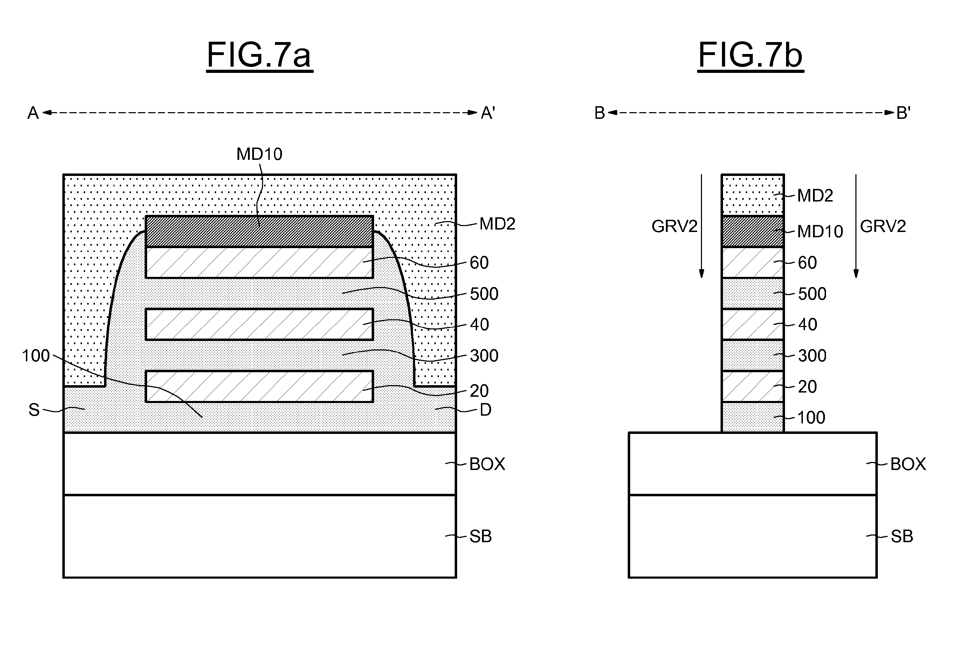

On procède alors à une deuxième gravure GRV2 avec arrêt sur la couche isolante de base BOX. Cette gravure peut être une gravure par plasma par exemple (figures 7a et 7b).

La gravure GRV2 permet de graver les régions de silicium RS1, RS2, et d'accéder à certaines des parois latérales des couches sacrificielles 20, 40 et 60, recouvertes précédemment par la couche épitaxiée de silicium. Il est alors possible, après la gravure de la couche de masque dur MD2 et grâce à une gravure isotrope sélective latérale GRL, de graver les trois couches sacrificielles 20, 40 et 60.

Les caractéristiques d'une telle gravure latérale sont bien connues de l'homme du métier et ont fait l'objet de nombreuses publications, notamment la demande de brevet français n° 2 791 178.

Plus précisément, on pourra utiliser par exemple une chimie oxydante bien connue telle qu'une solution 40ml HNO₃ à 70% + 20ml H₂O₂ + 5ml HF 0,5%, ou bien une attaque plasma isotrope.

Il convient de noter ici que, bien que tout matériau sélectivement éliminable par rapport au silicium puisse convenir, les alliages Si₁₋ₓGeₓ sont recommandés car ils sont aisément éliminables sélectivement par une telle chimie oxydante ou par une attaque plasma isotrope. Ces alliages facilitent également la réalisation par épitaxie des couches fines initiales de silicium 1, 3 et 5.

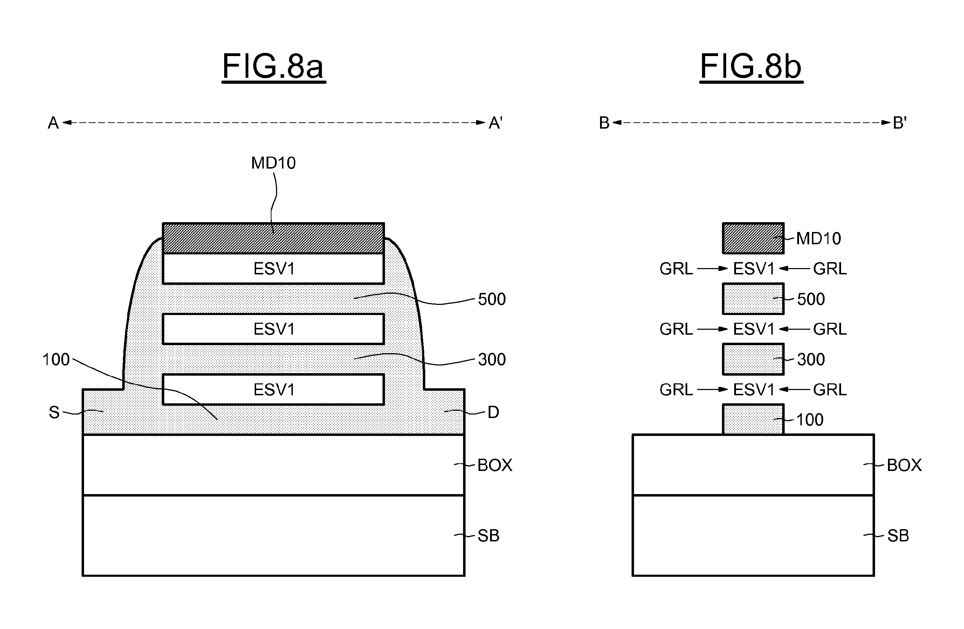

On crée alors, comme illustré sur les figures 8a et 8b, des espaces vides ESV1 autour des canaux 100, 300 et 500 qui forment un pont entre les régions de source S et de drain D. Les espaces vides ESV1 sont des cavités qui sont accessibles via les accès utilisés pour la gravure latérale GRL, mais qui sont également recouvertes par d'autres couches, dans le cas présent soit une couche de canal soit une couche de masque dur.

Les trois couches sacrificielles sont gravées de manière à former à la place les grilles du dispositif final.

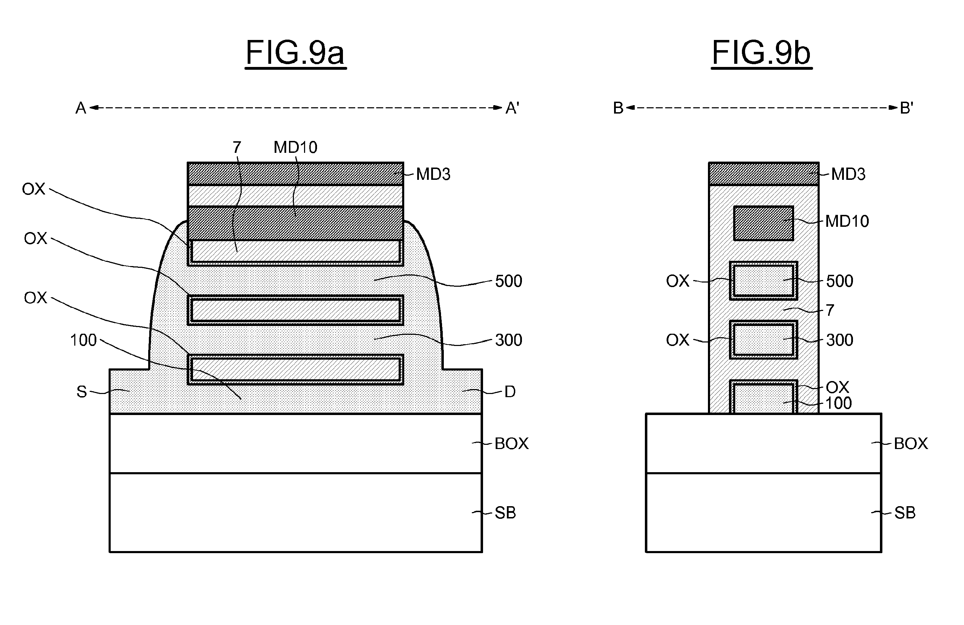

L'étape suivante, illustrée sur les figures 9a et 9b, consiste ainsi à remplir les cavités ou tunnels résultant de la gravure sélective isotrope des couches sacrificielles. Dans un premier temps, on forme donc sur les parois des espaces vides ESV1 ou cavités, une couche en matériau diélectrique OX de façon à assurer une isolation totale des flancs. En particulier, la couche en matériau diélectrique OX constitue l'isolant de grille du dispositif semi-conducteur final.

Cette couche en matériau diélectrique isolant OX peut être obtenue par exemple par un dépôt haute température d'un film d'oxyde TEOS. En variante, on peut utiliser comme matériau un matériau isolant connu par l'homme du métier sous la dénomination BSG ("Bore Silicone Glass" en langue anglaise) qui présente une meilleure sélectivité de gravure par rapport à l'oxyde de la couche BOX, que celle d'un oxyde TEOS.

On peut également procéder à une oxydation thermique, de façon à former à la surface des flancs en silicium des espaces vides ESV1, une fine couche OX d'oxyde de silicium.

Les espaces vides ESV1 sont ensuite remplis par une couche de premier matériau qui enrobe les canaux 300 et 500 de manière à ne former qu'une seule région de premier matériau 7.

Le premier matériau 7 peut être par exemple du poly-silicium formé par un dépôt CVD ou ALD, ou bien du poly-silicium-germanium. Les dépôts CVD ou ALD sont des dépôts conformes qui permettent de former une couche même sur les parois internes des cavités. Dans les deux cas, le premier matériau 7 est de préférence dopé au bore, par exemple fortement dopé au bore, afin de favoriser la diffusion du deuxième matériau semi-conducteur ou la substitution avec l'aluminium. Cela permet également d'obtenir, comme travail de sortie, une valeur adaptée aux transistors PMOS, c'est-à-dire une valeur comprise entre l'énergie supérieure de la bande de valence du silicium (5,12 eV) et la valeur de milieu de gap du silicium.

Un troisième bloc de résine MD3 est déposé sur la partie supérieure de la région de premier matériau 7 afin d'éviter la siliciuration du premier matériau pendant la siliciuration des régions de source S et de drain D.

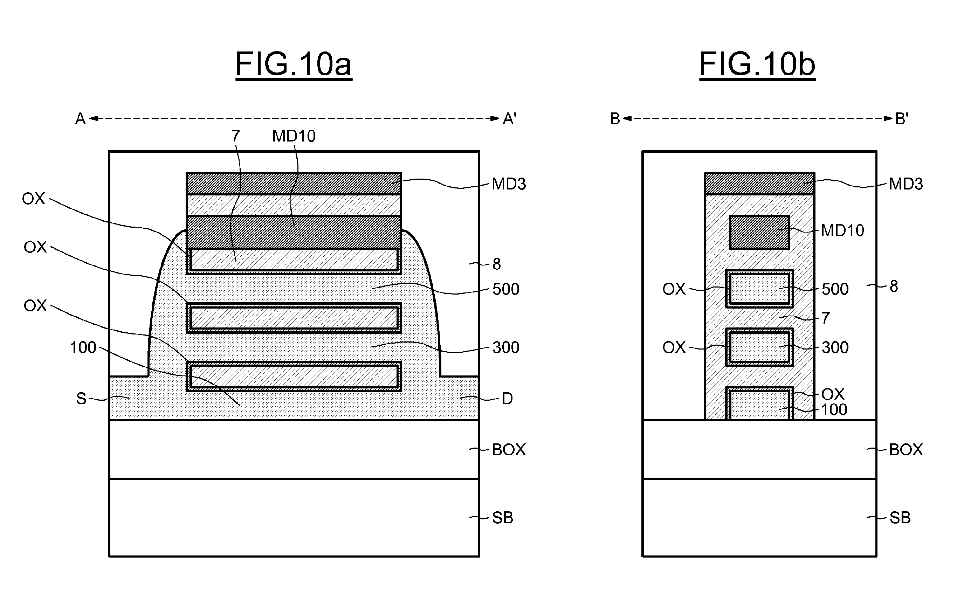

Les régions de source S et de drain D sont siliciurées (non-représenté) puis on recouvre le dispositif semi-conducteur par une couche diélectrique (PMD) 8 et on réalise une étape de polissage mécano-chimique (figures 10a et 10b).

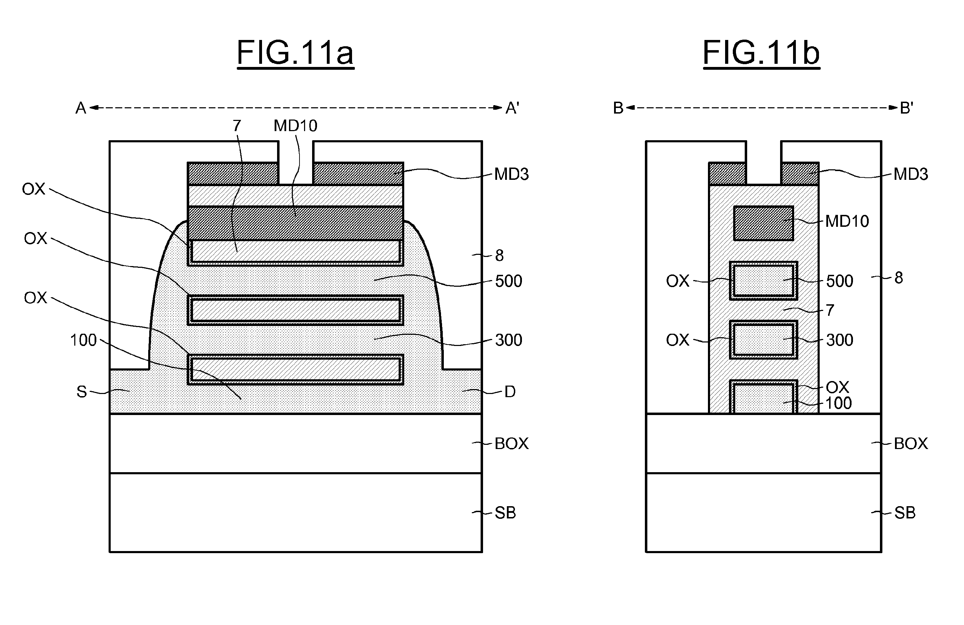

On réalise alors une ouverture dans la couche diélectrique 8 et dans le troisième bloc de résine MD3 de manière à atteindre la surface supérieure de la région de premier matériau 7 (figures 11a et 11b).

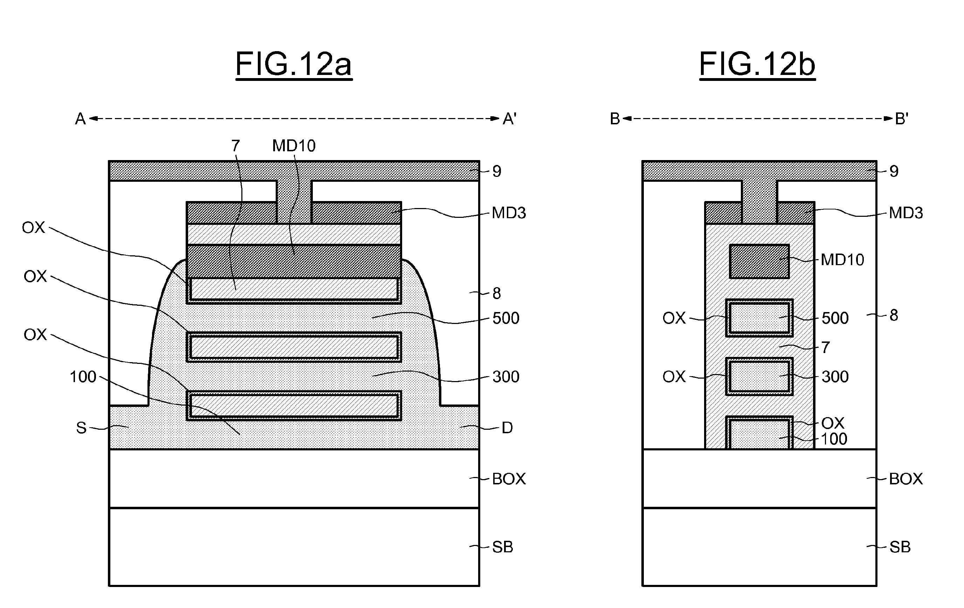

Selon un premier mode de mise en oeuvre (figures 12a et 12b), une couche d'un deuxième matériau semi-conducteur 9, différent du premier matériau, par exemple du germanium, est déposée de manière classique sur la couche diélectrique 8 et dans les ouvertures réalisées dans celle-ci. En particulier, il n'est pas nécessaire d'utiliser une méthode de dépôt conforme pour réaliser la couche de deuxième matériau 9, et il suffit que le deuxième matériau semi-conducteur soit en contact avec au moins une partie de la région de premier matériau 7.

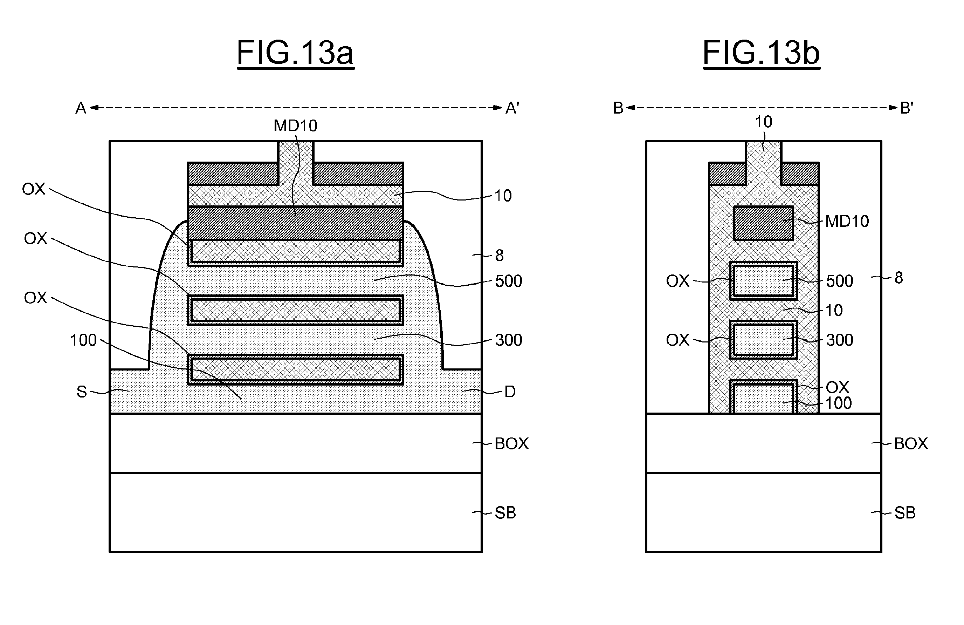

Il est alors possible de réaliser une étape de recuit au cours de laquelle la région de premier matériau 7 et la couche de deuxième matériau 9 vont former une région en alliage métallique qui est la région de grille 10 du dispositif semi-conducteur (figure 13a et 13b). Par exemple, lorsque le premier matériau est du poly-silicium et le deuxième matériau est du germanium, il est possible de former, durant l'étape de recuit, un alliage, en particulier amorphe ou poly-cristallin, de silicium/germanium. La température du recuit peut être compris entre 700°C et 900°C, par exemple de l'ordre de 800°C. L'alliage ainsi formé présente un comportement métallique de type P+, et permet donc d'obtenir un dispositif semi-conducteur PMOS. De plus, la proportion relative de germanium par rapport au silicium dans la région de grille 10 permet d'ajuster le travail de sortie de l'alliage, et donc la tension de seuil du dispositif PMOS. Notamment, la durée du recuit permet d'ajuster la proportion relative de germanium dans l'alliage de grille 13 et donc la tension de seuil du dispositif semi-conducteur.

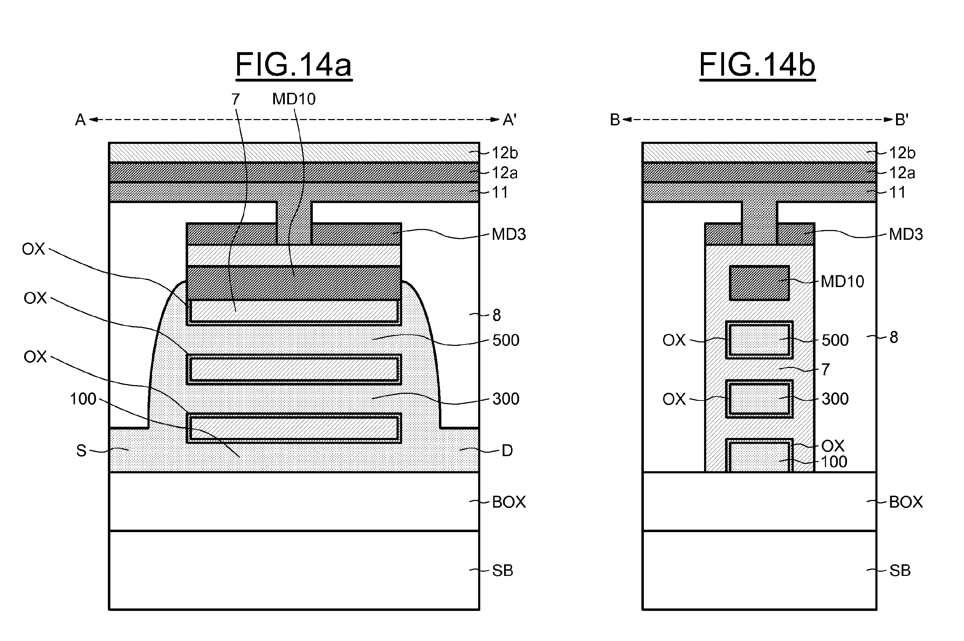

Selon un deuxième mode de mise en oeuvre (figures 14a et 14b), on dépose une couche 11 d'aluminium sur la couche diélectrique 8 et dans les ouvertures de celle-ci. De plus, afin de favoriser l'étape de substitution du premier matériau par l'aluminium, on dépose, sur la couche d'aluminium 11, une couche, dite de piégeage, 12a, , et éventuellement une couche, dite de barrière, 12b, déposée sur la couche 12a.

L'épaisseur et la surface de la couche 11 d'aluminium sont déterminées de façon à ce que le volume de celle-ci, disponible au niveau de la surface de contact entre la couche 11 et la région 7, soit en excès par rapport au volume de la région 7.

La couche de piégeage 12a comprend un matériau capable de fixer le premier matériau diffusant dans celle-ci. Le matériau est également choisi de manière à ne pas être très réactif vis-à-vis des matériaux de parois de la cavité et vis-à-vis du diélectrique de grille. On peut ainsi utiliser une couche 12a comprenant du titane, par exemple une couche de titane ou de nitrure de titane. Les dimensions de la couche 12a sont choisies de manière à permettre le piégeage du volume total du premier matériau de la région 7, en tenant compte notamment de l'alliage formé par le piégeage du premier matériau par le matériau de la couche 12a.

La couche de piégeage 12a permet donc de capturer le premier matériau présent dans l'aluminium au cours de la substitution, et donc permet d'appauvrir en continu la concentration de premier matériau dans l'aluminium de la couche 11. On peut ainsi obtenir une grille métallique dont les caractéristiques en terme de résistivité et de travail de sortie sont peu dépendantes de la concentration résiduelle du premier matériau dans l'aluminium.

La couche de barrière 12b comprend un matériau inerte, par exemple du nitrure de titane, qui agit comme une barrière vis-à-vis des impuretés et gaz extérieurs (par exemple l'atmosphère résiduelle lors du traitement thermique) qui pourraient réagir avec la couche de piégeage 12a et donc consommer une partie de celle-ci.

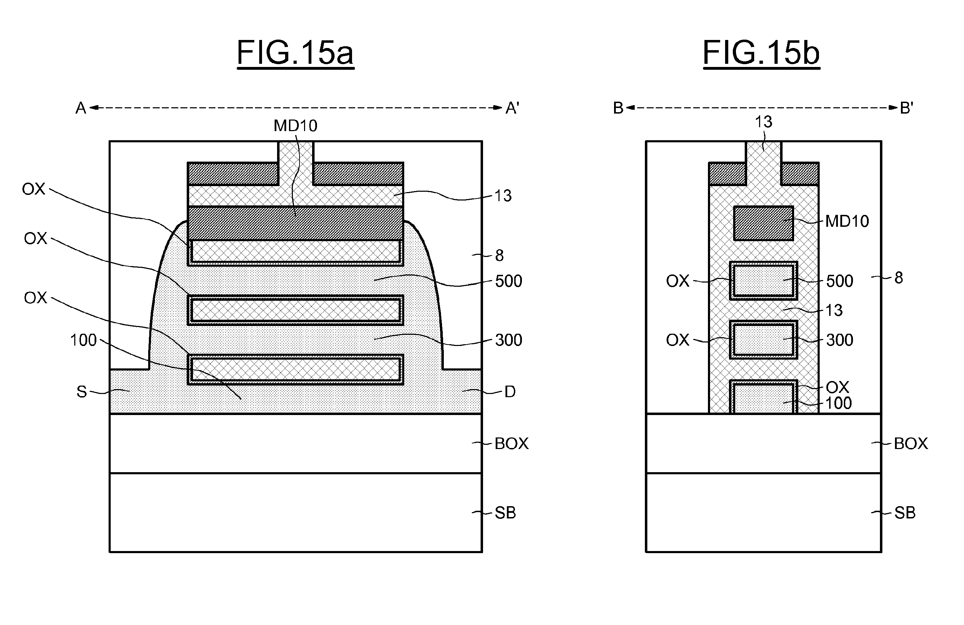

L'étape de recuit permet d'effectuer une substitution du premier matériau (notamment déposé dans les cavités ESV1) par l'aluminium. L'étape de recuit s'effectue par exemple à une température comprise entre 350°C et 425°C. On obtient alors, à la fin de l'étape de substitution, une région de grille 13 en aluminium et donc métallique. Quant au premier matériau précédemment contenu dans la région de premier matériau 7, il se retrouve alors au-dessus de la région de grille 13 et peut être retiré par gravure avec le titane et le nitrure de titane, et éventuellement le reliquat d'aluminium (figures 15a et 15b).

En particulier, la température de l'étape de substitution est choisie de façon à être compatible avec les étapes réalisées précédemment, notamment lorsqu'elle est réalisée à la fin du procédé. Ainsi, lorsque l'étape de substitution a lieu après une étape de siliciuration des jonctions à base de nickel, il est possible d'utiliser une température de l'ordre de 350°C pour la substitution. Dans ce cas, la substitution est effective en quelques dizaines de minutes pour des longueurs de substitution de plusieurs microns, tout en étant compatible avec le siliciure de nickel formé au niveau des jonctions.

L'aluminium présentant un comportement de type N+, on obtient avec le deuxième mode de mise en oeuvre, un dispositif semi-conducteur de type NMOS.

L'étape finale de la réalisation du composant consiste en des prises de contact classiques au niveau des zones de grille (en aluminium ou en alliage poly-silicium-germanium). Il convient de noter ici qu'un tel composant peut être facilement incorporé au sein d'un circuit intégré disposé sur une autre plaquette par exemple (concept Cellule sur Puce : COC ("Cellule on Chip" en langue anglaise).

Le dispositif ainsi obtenu, comporte dans le mode de réalisation illustré sur les figures 13a et 13b, ou 15a et 15b, une région de source S, de canal (100, 300, 500), de drain D et de grille métallique 10 ou 13 respectivement. Par ailleurs, les régions de source, de canal et de drain sont totalement isolées du substrat SB d'une part et de la région de grille d'autre part, par un enrobage isolant OX et par la couche BOX. Plus particulièrement, dans les cas décrits précédemment, les dispositifs semi-conducteurs comprennent trois canaux 100, 300, 500 dont deux (300, 500) sont enrobés par la grille.

Selon un troisième mode de mise en oeuvre, il est possible d'intégrer des dispositifs semiconducteurs de type différent (NMOS et PMOS) en réalisant simultanément les principales étapes décrites précédemment. Dans ce troisième mode de mise en oeuvre, le type des dispositifs semi-conducteurs formés peut être déterminé lors de la mise en contact du premier matériau avec le deuxième matériau semi-conducteur ou avec l'aluminium, c'est-à-dire que les dispositifs semi-conducteurs de type différent vont être réalisés de manière analogue mais avec des matériaux de grille différents.

Ainsi, on réalise les premières étapes du procédé de manière commune aux deux types de dispositifs semi-conducteurs, à l'exception de l'étape de réalisation de la couche de deuxième matériau ou d'aluminium. En effet, selon que le matériau de la couche de deuxième matériau est de l'aluminium ou du germanium, on va réaliser respectivement un dispositif semi-conducteur NMOS ou un dispositif semi-conducteur PMOS.

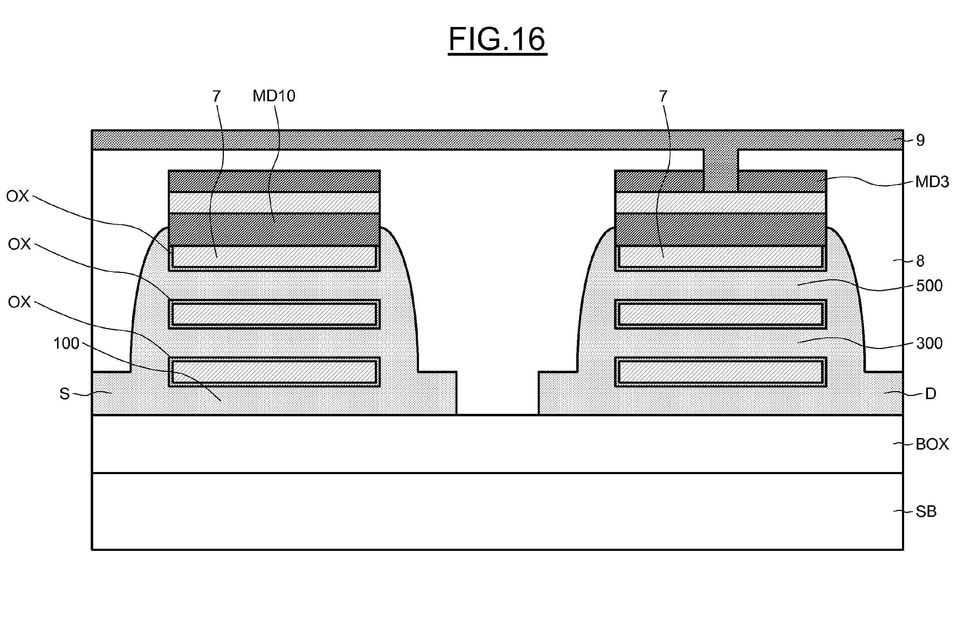

Ainsi, lorsque la couche diélectrique 8 est formée, les procédés de réalisation diffèrent entre les deux types de dispositifs semi-conducteurs : on commence alors, par exemple, par ouvrir des ouvertures pour atteindre la région de premier matériau 7 des dispositifs semi-conducteurs PMOS. On forme ensuite la couche de deuxième matériau 9 en germanium qui vient en contact avec la région de premier matériau 7 seulement au niveau des dispositifs semi-conducteurs PMOS (figure 16).

Un premier recuit, à une température d'environ 900°C, permet de former le poly-silicium-germanium et d'obtenir ainsi des dispositifs semi-conducteurs PMOS avec une région de grille 10, tandis que les autres dispositifs semi-conducteurs restent recouverts par la couche diélectrique 8.

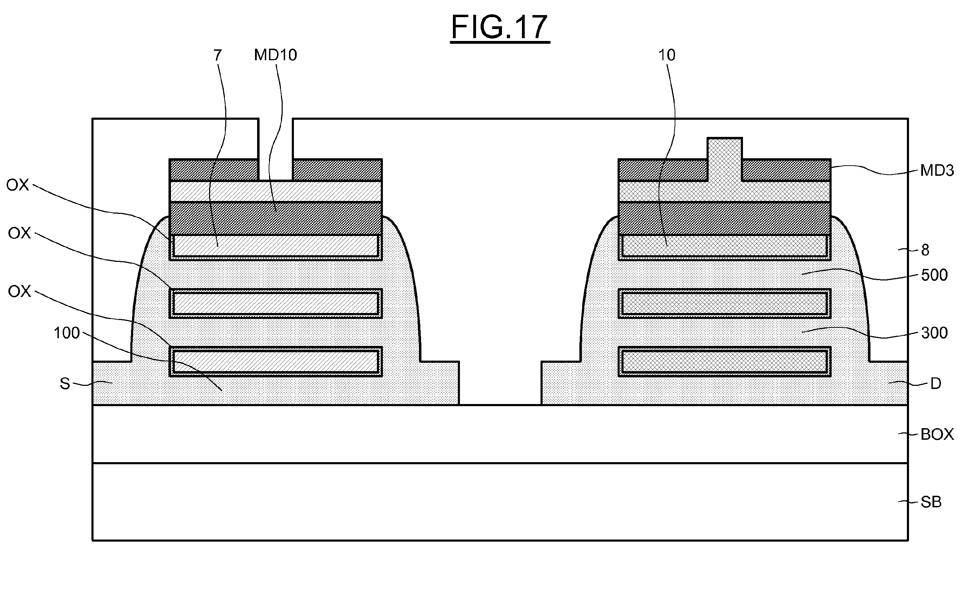

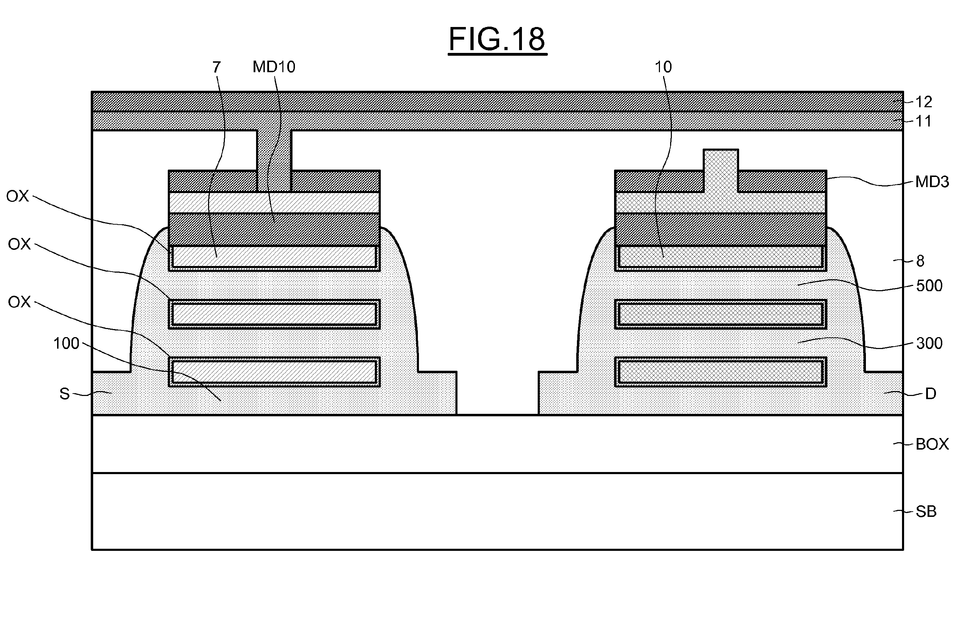

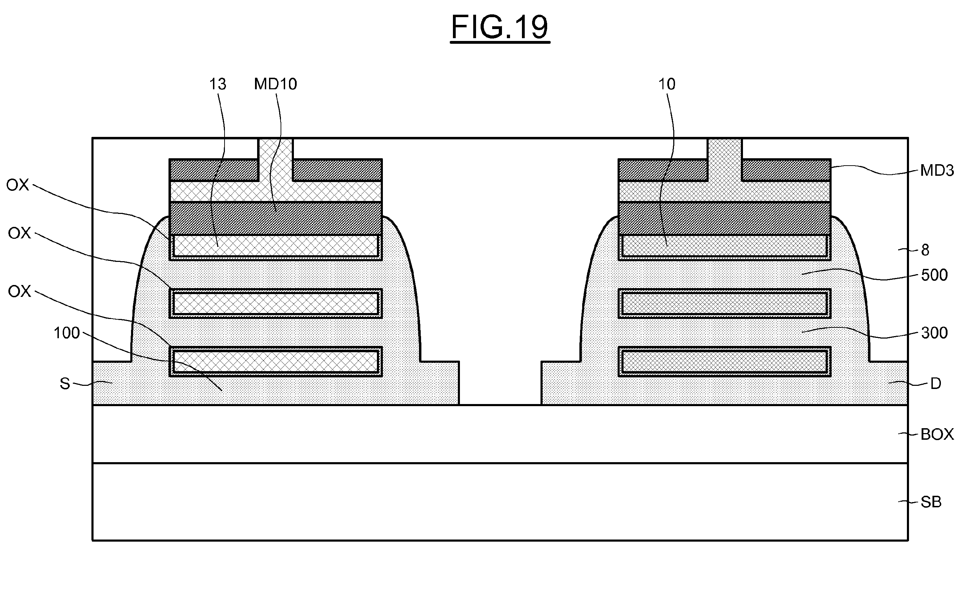

On dépose alors un matériau diélectrique de manière à ce que la couche diélectrique 8 recouvre à nouveau les deux dispositifs semi-conducteurs, puis on réalise des tranchées pour atteindre la couche de premier matériau 7 des dispositifs semi-conducteurs NMOS (figure 17) et on dépose la couche de deuxième matériau 11 en aluminium (recouverte par une couche de titane 12) en contact avec ladite région de premier matériau 7 (figure 18). Un deuxième recuit, à une température d'environ 400°C, permet à présent de former le poly-silicium-germanium et d'obtenir ainsi les dispositifs semi-conducteurs NMOS avec une région de grille 13 (figure 19).

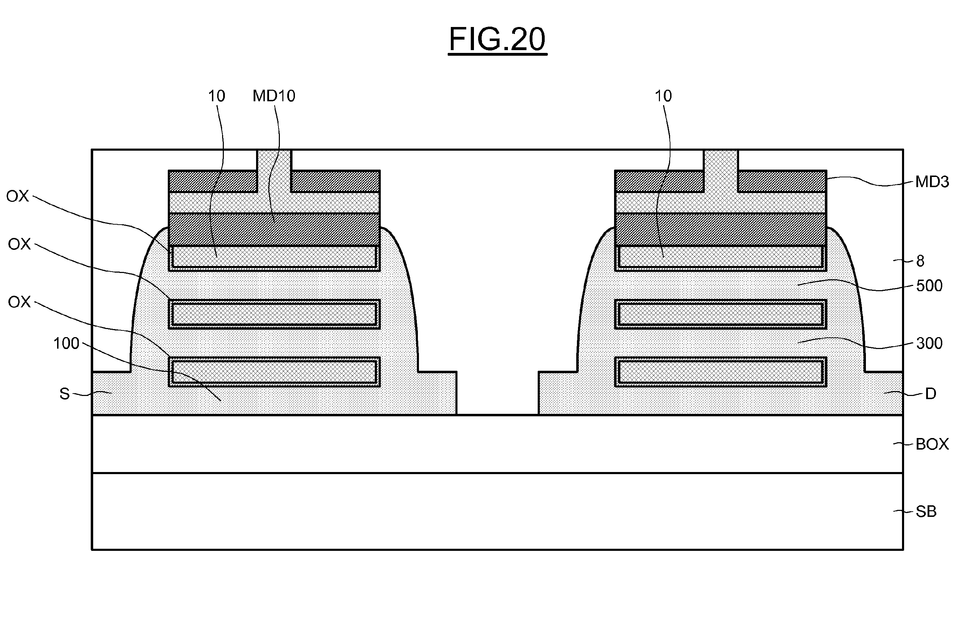

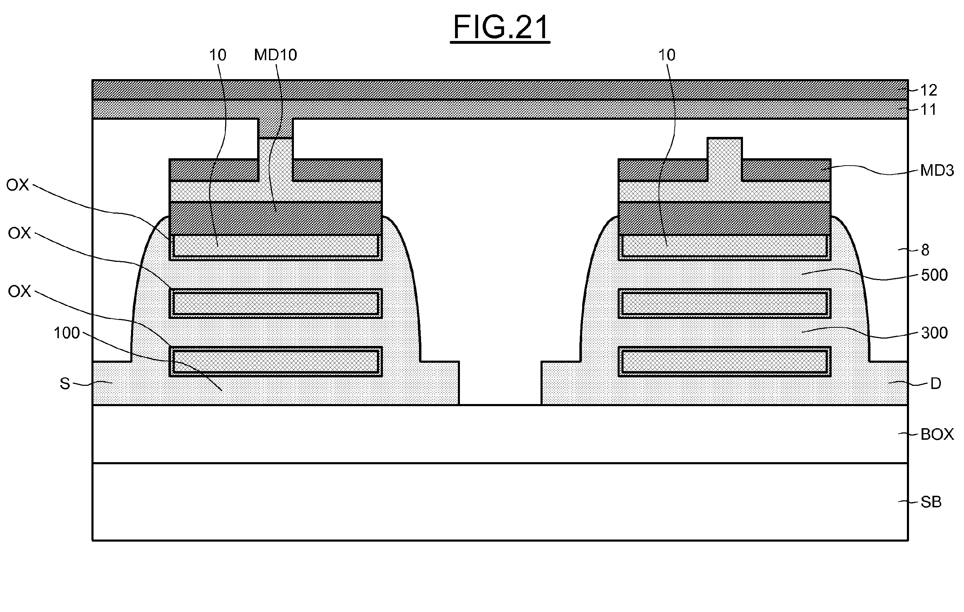

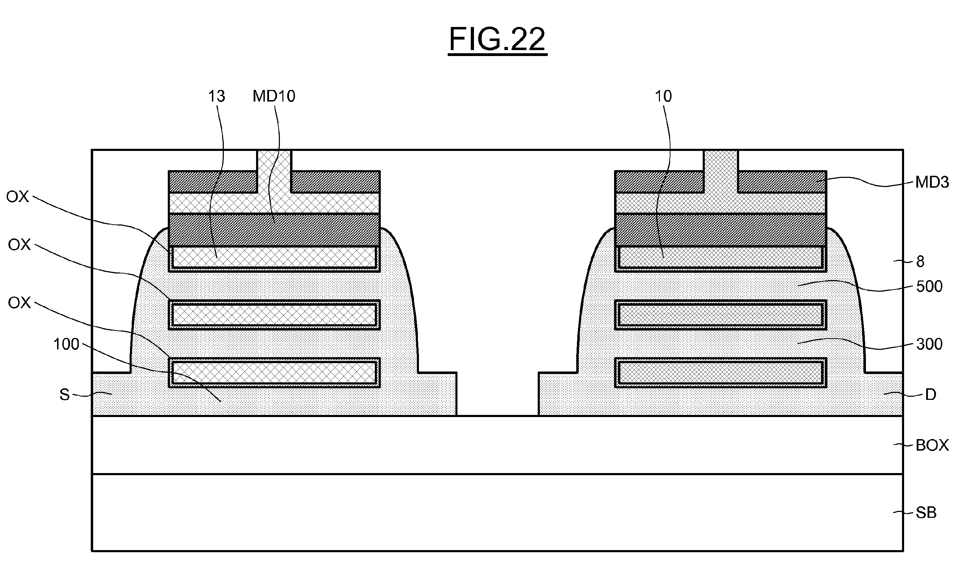

On peut noter, par ailleurs, que l'étape de substitution par l'aluminium peut également s'effectuer avec une région de premier matériau 7 comprenant du poly-silicium-germanium. Ainsi, pour réaliser les deux dispositifs semi-conducteurs NMOS et PMOS, il est également possible de réaliser que des dispositifs semi-conducteurs PMOS selon le procédé de diffusion de germanium dans le silicium (figure 20). On dépose alors un matériau diélectrique de manière à ce que la couche diélectrique 8 recouvre à nouveau les deux dispositifs semi-conducteurs, puis on réalise des ouvertures dans la couche diélectrique 8 au niveau des dispositifs semi-conducteurs qui doivent être NMOS. Une couche d'aluminium 11 (recouverte par une couche de nitrure 12) est alors déposée sur la couche diélectrique 8 et en contact avec la région de poly-silicium-germanium 10 des dispositifs semi-conducteurs que l'on souhaite être NMOS (figure 21). Un recuit de substitution permet de former les dispositifs semiconducteurs NMOS (figure 22).

Ainsi, les différents procédés décrits précédemment permettent de conserver des étapes standard de réalisation de dispositifs semi-conducteurs. En particulier, le remplacement du poly-silicium par le métal de grille à la fin du procédé permet d'éviter notamment les problèmes de réactivité du métal avec l'oxyde de grille durant la réalisation du dispositif semi-conducteur notamment.

## Revendications

1. Procédé de fabrication d'un dispositif semi-conducteur comportant une région semi-conductrice de canal et une région de grille, la région de grille comprenant au moins une partie enterrée s'étendant sous la région de canal, **caractérisée par le fait que** la formation de la partie enterrée de la région de grille comprend :
- une formation d'une cavité sous la région de canal,
- le remplissage de la cavité par un premier matériau,
- la mise en contact avec le premier matériau, d'aluminium ou d'un deuxième matériau semi-conducteur différent du premier matériau,
- une substitution du premier matériau par l'aluminium, ou la formation d'un troisième matériau par diffusion du second matériau semi-conducteur dans le premier matériau.

2. Procédé selon la revendication 1 dans lequel la formation de la partie enterrée de la région de grille comprend également :
- la mise en contact avec le troisième matériau, d'aluminium, et
- une substitution du troisième matériau par l'aluminium.

3. Procédé selon la revendication 1 ou 2 dans lequel le remplissage de la cavité comprend un dépôt conforme du premier matériau dans la cavité, et dans lequel l'étape de substitution ou de diffusion comprend un recuit.

4. Procédé selon l'une des revendications précédentes dans lequel on choisit la quantité relative du premier matériau et du deuxième matériau semi-conducteur dans la partie enterrée de la grille, pour ajuster la tension de seuil du dispositif semi-conducteur.

5. Procédé selon l'une des revendications précédentes dans lequel la quantité relative du premier matériau et du deuxième matériau semi-conducteur dans la partie enterrée de la grille est ajustée par la durée du recuit.

6. Procédé selon l'une des revendications précédentes dans lequel la formation de la grille comprend :
- la formation sur la surface supérieure du substrat d'un empilement formé d'au moins une couche de silicium placée au-dessus d'une couche sacrificielle formée d'un matériau sélectivement éliminable par rapport au silicium,
- une croissance par épitaxie de silicium sur les parois latérales de l'empilement,
- une gravure anisotrope de l'empilement de manière à graver une partie du silicium épitaxié et à accéder à au moins une des extrémités de la couche sacrificielle,
- une gravure isotrope sélective de la couche sacrificielle,
- la formation, sur les parois de la cavité résultant de la gravure isotrope, d'une couche comprenant un matériau diélectrique,
- le dépôt conforme, dans la cavité, du premier matériau,
- le dépôt de l'aluminium ou du deuxième matériau semi-conducteur en contact avec le premier matériau, et
- un recuit de formation du matériau de grille.

7. Procédé selon l'une des revendications précédentes dans lequel la formation de la région de grille comprend le dépôt conforme du premier matériau autour de la partie de la région semi-conductrice de canal de manière à ce que la région de grille enrobe la région semi-conductrice de canal.

8. Dispositif semi-conducteur comportant une région semi-conductrice de canal et une région de grille, la région de grille comprenant au moins une partie enterrée s'étendant sous la région de canal, **caractérisé en ce que** la partie enterrée de la région de grille comprend de l'aluminium ou un alliage d'un premier matériau et d'un deuxième matériau semi-conducteur.

9. Dispositif selon la revendication 8 dans lequel l'alliage du premier matériau et du deuxième matériau semi-conducteur comprend une proportion relative en premier matériau et en deuxième matériau semi-conducteur permettant d'obtenir une tension de seuil souhaitée pour le dispositif semi-conducteur.

10. Dispositif selon la revendication 8 ou 9 dans lequel la région de grille enrobe la région de canal.

11. Circuit intégré comprenant un dispositif selon l'une des revendications 8 à 10.
